(19) Europäisches Patentamt / European Patent Office / Office européen des brevets

(11) **EP 4 030 241 A1**

(12) **DEMANDE DE BREVET EUROPEEN**

(43) Date de publication:
**20.07.2022 Bulletin 2022/29**

(21) Numéro de dépôt: **21152156.2**

(22) Date de dépôt: **18.01.2021**

(51) Classification Internationale des Brevets (IPC):
**G04B 17/06** (2006.01) **G04D 7/10** (2006.01)
**G04D 7/12** (2006.01) **B81C 1/00** (2006.01)

(52) Classification Coopérative des Brevets (CPC):
**B81C 1/00682; G04B 17/066; G04D 7/10;**
**G04D 7/1285;** B81C 2201/0178

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(71) Demandeur: **Richemont International S.A.
1752 Villars-sur-Glâne (CH)**

(72) Inventeurs:
• **TOBENAS, Susana
2017 Boudry (CH)**
• **GUILLAUME, Marc
25520 Goux-les-Usiers (FR)**

(74) Mandataire: **Poindron, Cyrille et al
Novagraaf International SA
Chemin de l'Echo 3
1213 Onex (CH)**

(54) **PROCEDE DE FABRICATION DE RESSORTS SPIRAUX D'HORLOGERIE**

(57) L'invention concerne un procédé de fabrication de spiraux d'horlogerie, comprenant les étapes de :
- a. former une pluralité de spiraux dans une plaquette selon des dimensions prédéterminées,
- b. évaluer la raideur et/ou une dimension d'au moins un desdits spiraux,
- c. modifier la raideur et/ou la dimension d'au moins certains desdits spiraux, par retrait ou ajout d'une quantité incrémentale et prédéterminée de matière,
- d. répéter l'étape b. et éventuellement l'étape c. si le résultat de l'étape b. indique que la raideur et/ou la dimension n'est pas dans une plage de tolérance prédéfi-nie.

FIG. 1

**Description**

**Domaine technique**

La présente invention se rapporte au domaine de la micro-fabrication de pièces pour l'horlogerie. L'invention concerne plus particulièrement encore un procédé de fabrication de ressorts spiraux d'horlogerie.

**Etat de la technique**

Les mouvements de montres mécaniques sont régulés au moyen d'un régulateur mécanique comprenant un résonateur, c'est-à-dire un composant déformable élastiquement et dont les oscillations déterminent la marche de la montre. De nombreuses montres comportent par exemple un régulateur comprenant un spiral comme résonateur, monté sur l'axe d'un balancier et mis en oscillation grâce à un échappement. La fréquence propre du couple balancier-spiral permet de réguler la montre.

La raideur d'un résonateur de type spiral dépend de ses dimensions et en particulier de l'épaisseur (c'est-à-dire de la largeur) de ses spires le long de son barreau. La raideur est donnée plus spécifiquement par :

$$R = \frac{M}{\varphi}$$

avec :

$\psi$, l'angle de torsion du ressort, et
$M$, le couple de rappel du ressort spiral,

où M, pour un barreau de section constante constitué d'un matériau spécifique, est donné par :

$$M = \frac{E\left(\frac{e^3 h}{12}\varphi\right)}{L}$$

avec :

E, le module d'Young du matériau employé pour le barreau,
L, la longueur du barreau,
h, la hauteur du barreau, et
e, l'épaisseur ou la largeur du barreau.

La fréquence propre de résonance du spiral est proportionnelle à la racine carrée de sa raideur. La spécification principale d'un ressort spiral est sa raideur, qui doit se trouver dans un intervalle bien défini pour pouvoir être appairé avec un balancier, qui forme l'élément inertiel de l'oscillateur. Cette opération d'appairage est indispensable pour régler précisément la fréquence d'un oscillateur mécanique.

Il est très important que les caractéristiques de l'oscillateur soient aussi stables que possible, afin d'avoir une marche de la montre qui soit également stable. L'importance des champs magnétiques dans l'environnement moderne, a poussé les horlogers à utiliser depuis quelques années, des spiraux en silicium, moins sensible aux perturbations magnétiques que des spiraux métalliques.

Très avantageusement, on peut fabriquer plusieurs centaines de spiraux en silicium sur une seule plaquette (en anglais « wafer ») en utilisant les technologies de micro-fabrication. Il est notamment connu de réaliser une pluralité de résonateurs en silicium avec une très haute précision un utilisant des procédés de photolithographie et d'usinage / gravure dans une plaquette en silicium. Les procédés de réalisation de ces résonateurs mécaniques utilisent généralement des plaquettes de silicium monocristallin, mais des plaquettes en d'autres matériaux sont également utilisables, par exemple en silicium polycristallin ou amorphe, en d'autres matériaux semi-conducteur, en verre, en céramique, en carbone ou en un composite comprenant ces matériaux. Pour sa part, le silicium monocristallin appartient à la classe cristalline cubique m3m dont le coefficient d'expansion thermique (alpha) est isotrope.

Le silicium présente une valeur du premier coefficient thermoélastique très négative, et par conséquent, la raideur d'un résonateur en silicium, et donc sa fréquence propre, varie fortement selon la température. Afin de compenser au moins partiellement cet inconvénient, les documents EP1422436, EP2215531 et WO2016128694 décrivent un résonateur mécanique de type spiral réalisé à partir d'une âme (ou de deux âmes dans le cas de WO2016128694) en silicium monocristallin et dont les variations en température du module d'Young sont compensées par une couche en oxyde de silicium (Si02) amorphe entourant l'âme (ou les âmes), ce dernier étant un des rares matériaux présentant un coefficient thermoélastique positif.

Lorsque l'on réalise des spiraux en silicium ou en un autre matériau par fabrication collective sur une plaquette, le rendement fonctionnel final sera donné par le nombre de spiraux dont la raideur correspond à l'intervalle d'appairage, divisé par le nombre total de spiraux sur la plaquette.

Cependant, les étapes de micro-fabrication et plus particulièrement de gravure employées dans la fabrication de spiraux sur une plaquette résultent typiquement en une dispersion géométrique importante entre les dimensions des spiraux d'une même plaquette, et donc d'une dispersion importante entre leurs raideurs, nonobstant que le motif de gravure est le même pour chaque spiral. La dispersion de raideur mesurée suit normalement une distribution gaussienne. Afin d'optimiser le rendement de fabrication, on s'intéresse donc à centrer la moyenne de la distribution gaussienne sur une valeur de raideur nominale et également à réduire l'écart-type de cette gaussienne.

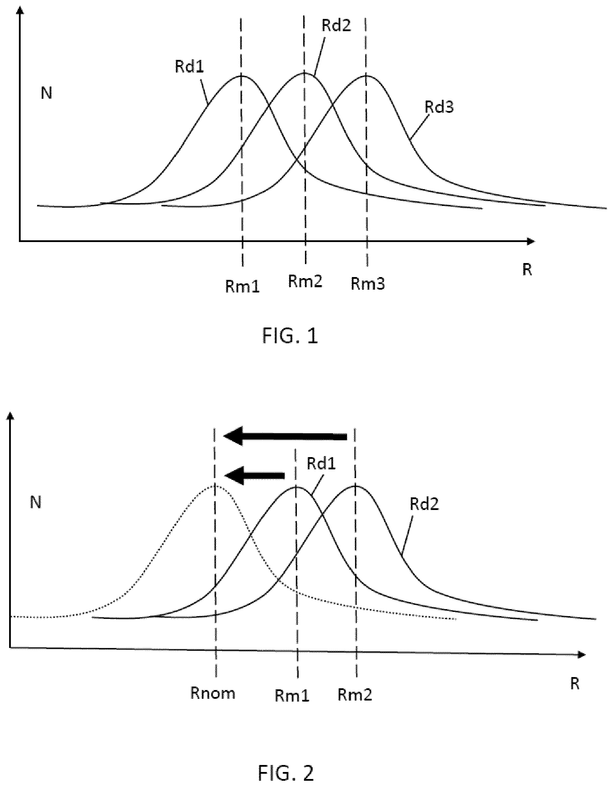

De plus, la dispersion de raideurs est encore plus grande entre des spiraux de deux plaquettes gravées à des moments différents suivant les mêmes spécifications de procédé. Ce phénomène est montré à la figure 1 où les courbes de dispersion de la raideur Rd1, Rd2 et Rd3 pour les spiraux sur trois plaquettes différentes sont illustrées. De manière générale, pour chaque plaquette la distribution des raideurs R (par rapport au nombre de spiraux N avec cette raideur) suit la loi normale ou gaussienne, chaque courbe de dispersion étant centrée sur sa valeur moyenne respective Rm1, Rm2 et Rm3.

Les documents WO2015113973 et EP3181938 proposent de remédier à ce problème en formant un spiral selon des dimensions supérieures aux dimensions nécessaires pour l'obtention d'un spiral d'une raideur prédéterminée, en mesurant la raideur de ce spiral formé, en calculant l'épaisseur de matériau à retirer pour obtenir les dimensions nécessaires pour l'obtention du spiral avec la raideur prédéterminée, et en retirant cette épaisseur du spiral. De manière similaire, le document EP3181939 propose de remédier ce même problème en formant un spiral selon des dimensions inférieures aux dimensions nécessaires pour l'obtention d'un spiral d'une raideur prédéterminée, en déterminant la raideur de ce spiral formé, en calculant l'épaisseur de matériau à ajouter pour obtenir les dimensions nécessaires pour l'obtention du spiral avec la raideur prédéterminée, et en ajoutant cette épaisseur de matériau au spiral.

De cette manière, comme le démontre la figure 2, nonobstant la raideur moyenne Rm1, Rm2, etc. des raideurs sur une plaquette donnée, la courbe de dispersion de raideurs Rd1, Rd2, etc. peut-être recentrée par rapport à une valeur de raideur nominale Rnom.

Cette approche quantitative nécessite une grande précision au niveau de la mesure de la fréquence du spiral pour déterminer sa raideur. On doit ensuite réaliser une étape de calcul de l'épaisseur à retirer pour, à nouveau, retirer avec une grande précision l'épaisseur calculée.

La précision requise, et la réalisation des étapes de calculs, ralentissent le flux de production et obligent en pratique à réaliser des échantillonnages et en déduire des caractéristiques de spiraux qui n'ont pas été mesurés.

La présente invention a pour but de proposer une approche exempte des inconvénients ci-dessus, qui permette un flux de production plus rapide et/ou un échantillonnage plus important, et donc une correction plus individualisée des spiraux de la plaquette.

## Divulgation de l'invention

De façon plus précise, l'invention concerne un procédé de fabrication de spiraux d'horlogerie, comprenant les étapes de :

a. former une pluralité de spiraux dans une plaquette selon des dimensions prédéterminées,

b. évaluer la raideur et/ou une dimension d'au moins un desdits spiraux,

c. modifier la raideur et/ou la dimension d'au moins certains desdits spiraux, par retrait ou ajout d'une quantité incrémentale et prédéterminée de matière,

d. répéter l'étape b. et éventuellement l'étape c. si le résultat de l'étape b. indique que la raideur et/ou la dimension n'est pas dans une plage de tolérance prédéfinie.

De manière avantageuse, l'approche proposée par l'invention permet, particulièrement pour les méthodes d'évaluation qui sont effectuées directement sur la plaquette, d'intégrer ces étapes de manière très efficace dans le flux de production. En effet, l'invention propose une approche qualitative qui permet d'éviter de calculer une épaisseur de matière à retirer, et permet d'éviter de devoir ajuster les paramètres de l'étape de correction pour retirer précisément l'épaisseur calculée.

Par approche qualitative, on définit une approche qui évalue la nature du spiral obtenu, en ce qu'il est conforme aux spécifications attendues, dans la plage de tolérance attendue, ou non. Le résultat de l'évaluation qualitative n'est pas numérique, il n'est pas une quantité, ni un écart de raideur par rapport à une valeur cible, mais une validation de type verbal, par exemple, « inférieur », « ok », « supérieur », par rapport à la plage de tolérance. A l'opposé, une approche quantitative détermine une donnée chiffrée, numérique et le résultat d'une mesure quantitative de la raideur d'un spiral, est une valeur de raideur, à partir de laquelle on peut calculer précisément une épaisseur à corriger sur le spiral pour obtenir un spiral dont la raideur est la raideur cible.

On notera donc que, à la différence de l'art antérieur, la raideur des spiraux à fabriquer, n'est pas exactement prédéterminée. On détermine seulement une plage de tolérance cible.

Selon un mode de réalisation particulier, l'étape b. se fait par comparaison par rapport à une référence.

Dans une première variante, les dimensions prédéterminées sont supérieures à des dimensions cibles, et en ce que l'étape c. se fait par retrait de matière.

De manière préférée, le retrait de matière se fait par :

- une étape d'oxydation du spiral, afin de transformer en dioxyde de silicium un incrément d'épaisseur de silicium, d'une valeur prédéterminée et indépendante du résultat de l'évaluation de l'étape b,

- retirer au moins une partie du dioxyde de silicium du spiral précédemment oxydé.

L'étape de retrait de dioxyde de silicium conduit à laisser une couche résiduelle de dioxyde de silicium d'une épaisseur prédéterminée.

L'étape b. peut être réalisée par mesure de la fréquence dudit spiral couplé avec un balancier de référence doté d'une inertie connue, ou par mesure du couple du spiral, ou l'étape b. peut comprendre de telles étapes.

La mesure du couple peut être réalisée par mise en rotation de la virole, alors que la dernière spire du spiral est attachée.

Selon un mode de réalisation préféré, l'étape b. est effectuée sur un échantillonnage de spiraux, répartis par région sur la plaquette et en ce que l'étape c. est effectuée de manière différentielle par région, en fonction du résultat de l'étape b.

De manière avantageuse, la quantité incrémentale et prédéterminée de matière ajoutée ou retirée à l'étape c est indépendante de l'évaluation de la raideur et/ou de la dimension effectuée à l'étape b.

De manière préférée, l'étape b. comprend une étape consistant à classifier ou catégoriser la raideur et/ou la dimension dans des classes ou catégories incrémentales de raideur et/ou de dimension.

Dans ce cas, on pourra prévoir au moins deux classes de raideur et/ou de dimension sont définies comme suit :

- raideur et/ou dimension trop faible, auquel cas, l'étape c comprend l'ajout d'une quantité incrémentale et prédéterminée de matière,
- raideur et/ou dimension trop grande, auquel cas, l'étape c comprend le retrait d'une quantité incrémentale et prédéterminée de matière.

**Brève description des dessins**

D'autres détails de l'invention apparaîtront plus clairement à la lecture de la description qui suit, faite en référence au dessin annexé dans lequel :

- la figure 1 montre les courbes de dispersion de raideurs non corrigées pour les spiraux sur trois plaquettes différentes,
- la figure 2 montre le centrage de la moyenne des raideurs sur une plaquette autour d'une valeur nominale,
- les figures 3A-3F sont une représentation simplifiée d'un procédé de fabrication d'un résonateur mécanique, ici un spiral, sur une plaquette, et
- la figure 4 représente un dispositif permettant l'évaluation du couple d'un spiral.

**Mode de réalisation de l'invention**

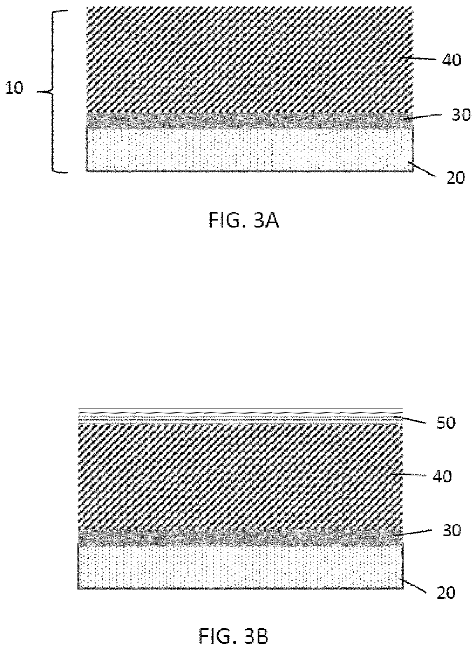

Les figures 3A-3F sont une représentation simplifiée d'un procédé de fabrication d'un résonateur mécanique 100 sur une plaquette 10. Le résonateur est notamment destiné à équiper un organe régulateur d'une pièce d'horlogerie et, selon cet exemple, est en forme d'un ressort spiral 100 en silicium qui est destiné à équiper un balancier d'un mouvement d'horlogerie mécanique.

La plaquette 10 est illustrée à la figure 3A en tant que wafer SOI (« silicon on insulator ») et comprend un substrat ou « handler » 20 portant une couche d'oxyde de silicium ($SiO_2$) sacrificielle 30 et une couche de silicium monocristallin 40. A titre d'exemple, le substrat 20 peut avoir une épaisseur de 500 $\mu$m, la couche sacrificielle 30 peut avoir une épaisseur de 2 $\mu$m et la couche en silicium 40 peut avoir une épaisseur de 120 $\mu$m. La couche de silicium monocristallin 40 peut avoir une orientation cristalline quelconque.

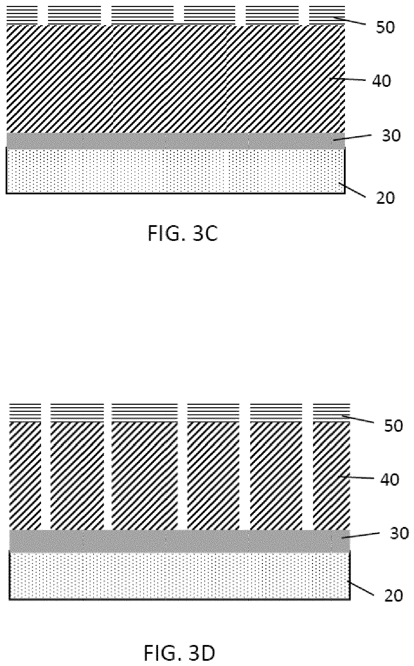

Une étape de lithographie est montrée aux figures 3B et 3C. Par « lithographie », on entend l'ensemble des opérations permettant de transférer une image ou motif sur ou au-dessus de la plaquette 10 vers cette dernière. En se référant à la figure 3B, dans ce mode de réalisation exemplaire, la couche 40 est recouverte d'une couche de protection 50, par exemple en une résine polymérisable. Cette couche 50 est structurée, typiquement par une étape de photolithographie utilisant une source de lumière ultraviolette ainsi que, par exemple, un photomasque (ou un autre type de masque d'exposition) ou un système de stepper et réticule. Cette structuration par lithographie forme les motifs pour la pluralité de résonateurs dans la couche 50, comme illustrée à la figure 3C.

Par la suite, dans l'étape de la figure 3D, les motifs sont usinés, notamment gravés, pour former la pluralité de résonateurs 100 dans la couche 40. La gravure peut être effectuée par une technique de gravure ionique réactive profonde (également connue sous l'acronyme DRIE pour « Deep Reactive Ion Etching »). Après la gravure, la partie restante de la couche de protection 50 est subséquemment éliminée.

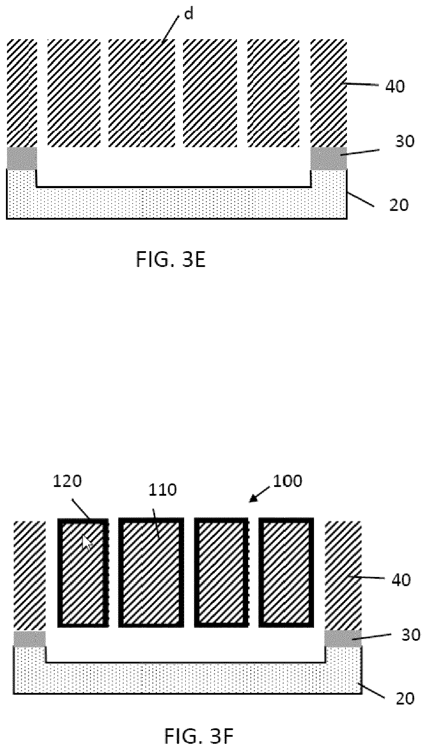

A la figure 3E, les résonateurs sont libérés du substrat 20 en retirant localement la couche sacrificielle 30 voire en gravant tout ou partie du silicium du substrat ou handler 20. Un lissage (non illustré) des surfaces gravées peut également avoir lieu avant l'étape de libération, par exemple par une étape d'oxydation thermique suivie par une étape de désoxydation, constituée par exemple de la gravure par voie humide à base d'acide fluorhydrique (HF).

A la dernière étape du procédé de fabrication à la figure 3F, les spires 110 du résonateur 100 en silicium sont recouvertes d'une couche 120 d'oxyde de silicium (Si02), typiquement par une étape d'oxydation thermique pour produire un résonateur thermocompensé. La formation de cette couche 120, qui a généralement une épaisseur de 2-5 $\mu$m, affecte également la raideur finale du résonateur et donc doit être prise en compte lors des étapes précédentes.

Comme indiqué ci-dessus, au stade précédent la réalisation de la couche de thermocompensation, les différents résonateurs formés dans la plaquette présentent généralement une dispersion géométrique importante entre eux et donc une dispersion importante entre leurs raideurs, nonobstant que les étapes de formation des motifs et de l'usinage/gravure à travers ces motifs sont les mêmes pour tous les résonateurs.

Par ailleurs, cette dispersion de raideurs est encore plus importante entre les spiraux de deux plaquettes gravées à des moments différents même si les mêmes spécifications de procédé sont utilisées.

Pour centrer la moyenne de raideurs des résonateurs sur différentes plaquettes par rapport à une valeur de raideur nominale comme illustré à la figure 2, les résonateurs obtenus à l'étape 3E sur la plaquette 10 en question peuvent être délibérément formés avec des dimensions d qui sont supérieures aux dimensions nécessaires pour l'obtention d'une raideur nominale ou cible.

Alors que les procédés de l'art antérieur proposent de mesurer les raideurs d'un échantillon de résonateurs sur la plaquette à l'étape 3E, et de calculer précisément l'épaisseur de matériau à retirer, autour de chaque spire, pour obtenir les dimensions correspondant à la raideur cible, la présente invention propose une autre approche.

Ainsi, l'invention propose, après avoir formé, lors d'une étape a., une pluralité de spiraux dans une plaquette, selon des dimensions prédéterminées, tel que décrit ci-dessus, d'effectuer les étapes suivantes :

- b. évaluer la raideur et/ou une dimension d'au moins un desdits spiraux,
- c. modifier la raideur et/ou la dimension d'au moins certains desdits spiraux, par retrait ou ajout d'une quantité incrémentale et prédéterminée de matière,
- d. répéter l'étape b. et éventuellement l'étape c. si le résultat de l'étape b. indique que la raideur et/ou la dimension n'est pas dans une plage de tolérance prédéfinie.

Ainsi, selon l'invention, au lieu d'une approche quantitative, dans laquelle on calcule puis implémente une correction aussi précisément que possible afin d'obtenir un spiral ayant des caractéristiques notamment de raideur, qui soient aussi proches que possible d'une valeur cible, prédéfinie, on préfère une approche qualitative, dans laquelle on effectue une correction de manière incrémentale. Autrement dit, on applique une dose de correction prédéfinie, de manière itérative, jusqu'à obtenir un spiral qui présente, avec une certaine tolérance, les caractéristiques souhaitées.

Par dose de correction, on définit, en fonction du type de correction utilisé (retrait ou ajout de matière), un ensemble de paramètres et d'étapes qui conduisent à effectuer le même incrément de correction, à chaque dose, c'est-à-dire d'ajouter une quantité incrémentale de matière ou, le cas échéant, de retirer une quantité incrémentale de matière.

Ainsi, on aura compris que la quantité incrémentale et prédéterminée de matière ajoutée ou retirée à l'étape c est indépendante de l'évaluation de la raideur et/ou de la dimension effectuée à l'étape b.

Par exemple, dans la première variante, on réalise des spiraux avec des dimensions supérieures aux dimensions nécessaires, on évalue lors de l'étape b. la raideur d'au moins un spiral, selon une des méthodes qui seront décrites ci-après. Cette évaluation, selon cet exemple, indiquera une raideur trop importante par rapport à une valeur cible. On effectue ensuite, la correction qui sera un retrait d'une quantité incrémentale de matière sur le spiral, homogène ou hétérogène le long de la spire.

Un tel retrait de matière peut ainsi être effectué, en procédant à une étape d'oxydation thermique suivie par une étape de désoxydation permettant un retrait fin et précis de la quantité de matériau.

Plus particulièrement, selon cette approche, la différence dimensionnelle est convertie en une valeur d'épaisseur d'oxyde à faire croître sachant qu'environ 44 % de la couche d'oxyde sera en dessous de la surface d'origine et 56 % au-dessus. Puisque la croissance de la couche d'oxyde thermique peut être contrôlée précisément, la quantité de matériau retirée est précisément répétable et contrôlable. Typiquement, on peut cibler la croissance d'une couche entre 50 nm et 250 nm, de préférence 100 nm.

Une fois la quantité de matière incrémentale retirée ou ajoutée, on évalue à nouveau la raideur du spiral évalué lors de la première itération. On compare à nouveau la raideur évaluée, avec la raideur cible.

Au niveau de l'étape b, celle-ci peut comprendre une étape consistant à classifier ou catégoriser la raideur dans des classes ou catégories de raideur. On peut avoir deux classes de raideur pouvant être définies comme suit :

- raideur trop faible, auquel cas, l'étape c comprend l'ajout d'une quantité incrémentale et prédéterminée de matière,
- raideur trop grande, auquel cas, l'étape c comprend le retrait d'une quantité incrémentale et prédéterminée de matière.

Si besoin, on effectue une nouvelle correction selon l'incrément prévu, jusqu'à obtenir une raideur conforme. Conforme implique une raideur qui se trouve dans une plage de tolérance prédéfinie, prévue pour correspondre à une certaine plage de raideur. On peut également prévoir une classe définie par une raideur conforme. Si, à l'étape b, le spiral considéré présente une raideur conforme, on n'effectue aucune correction. La plaquette peut être considérée conforme (selon l'échantillonnage des spiraux considéré sur la plaquette, comme on le mentionne ci-après) et apte à être utilisée dans la suite du flux de production.

Méthodes d'évaluation

Pour évaluer la raideur d'un spiral sur le wafer, plusieurs solutions sont offertes, comme notamment décrit par M. Vermot et al, dans le Traité de construction horlogère (2011) aux pages 178-179. On peut se contenter d'une simple évaluation, sans obtenir de valeur précise pour la raideur, permettant simplement d'effectuer une comparaison avec une référence. On peut également effectuer une mesure, permettant d'accéder à la valeur de raideur, pour effectuer cette comparaison avec la référence. Cependant, dans tous les cas, à la différence de l'état de la technique, on n'a pas besoin d'en déduire quantitativement, une correction à apporter, comme une épaisseur de matériau à retirer.

Par exemple, on peut effectuer une évaluation dynamique, en couplant le spiral à un balancier de référence dont on connait l'inertie. La mesure de la fréquence de l'ensemble permet de déduire la raideur du spiral, de manière précise. Cette évaluation peut être effectuée sur le wafer ou en détachant le spiral du wafer. Les références et antériorités données ci-dessus, fournissent des détails sur cette méthode. L'évaluation se fait simplement en comparant qualitativement si la fréquence obtenue, en associant le spiral avec un balancier d'inertie prédéterminée, est dans une plage de tolérance acceptable, prédéfinie.

De manière alternative, la mesure de raideur du spiral peut être effectuée de manière dite statique, c'est-à-dire sans mettre le spiral en oscillation, mais par détermination de son couple. On pourra par exemple se référer au document EP3654111.

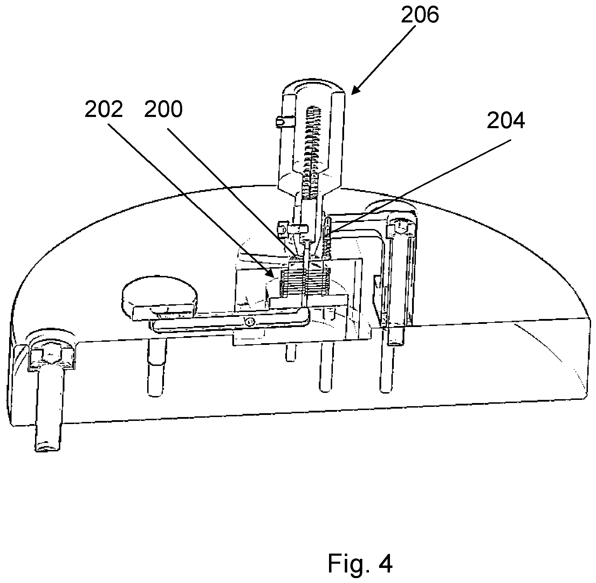

Une alternative à la méthode décrite dans ce dernier document, consiste à effectuer une mesure de couple à l'aide d'un rhéomètre, tel que commercialisé par la société Anton Paar. Un dispositif prévu dans ce but est illustré sur la figure 4. De manière avantageuse, il permet de disposer le spiral 200 à évaluer sur un posage 202, et de le positionner de manière à ce qu'il puisse être fixé au niveau de sa dernière spire par un organe de tenue 204. Une fois la dernière spire fixée, le posage 202 est éloigné du spiral 200 qui est ainsi totalement libre de toute contrainte élastique. La tête du rhéomètre 206 est alors positionnée en regard de la virole du spiral. Elle présente une contre-forme de la virole, non circulaire, mais avec une taille réduite, qui permet un engagement de la tête du rhéomètre dans la virole, avec une précision contrôlable, sans entrer en contact du spiral. La tête du rhéomètre est ensuite mise en rotation, dans une direction de contraction du spiral. Lorsque la tête entre au contact de la virole, elle l'entraîne et le rhéomètre mesure le couple exercé par le rappel élastique du spiral, sur un angle donné. A nouveau, si on peut déduire une valeur numérique de la raideur à partir de cette évaluation, il suffit simplement de comparer qualitativement si le couple obtenu est dans une plage de tolérance acceptable, prédéfinie.

Le protocole qui vient d'être décrit présente l'avantage de ne pas contraindre le ressort spiral de manière parasite lors de la mesure, notamment hors du plan, ce qui perturberait la mesure du couple.

La description ci-dessus fait directement référence à des évaluations ou mesures de la raideur du spiral, mais cette raideur est notamment liée, pour un matériau donné, aux dimensions de la section du barreau formant le spiral. Aussi, on peut établir de manière similaire un procédé de contrôle basé sur l'évaluation ou la mesure de certaines dimensions notamment l'épaisseur, des spires du spiral, pour déterminer si une correction incrémentale doit être appliquée, ou non.

**Echantillonnage**

On sait qu'on réalise plusieurs centaines de spiraux sur une plaquette et que les dimensions des spiraux réalisés peuvent varier selon les régions de la plaquette. Si l'évaluation de raideur peut être effectuée sur un seul spiral, en pratique, elle sera effectuée sur un échantillon de spiraux, répartis sur la plaquette.

A partir des évaluations effectuées, les corrections peuvent être différenciées par région, si les résultats obtenus varient d'un spiral à un autre. On peut ainsi réduire l'écart-type de la dispersion des raideurs.

Ainsi, lorsque l'étape b. indique qu'un spiral est conforme, on peut soumettre la validation d'une plaquette à la condition que plusieurs spiraux, éventuellement dans des régions différentes de la plaquette, soient tous conformes.

On peut même envisager d'aller jusqu'à une évaluation de tous les spiraux du wafer.

Bien que les exemples ci-dessus ont été donnés sur la base d'une fabrication de spiraux présentant des dimensions initiales plus grandes que les dimensions cibles, on peut également prévoir de réaliser des spiraux présentant des dimensions initiales plus petites que les dimensions cibles. L'étape de correction consiste alors à ajouter de la matière, comme par exemple décrit dans le document EP3181939 susmentionné.

**Revendications**

1. Procédé de fabrication de spiraux d'horlogerie, comprenant les étapes de :

    - a. former une pluralité de spiraux dans une plaquette selon des dimensions prédéterminées,
    - b. évaluer la raideur et/ou une dimension d'au moins un desdits spiraux,
    - c. modifier la raideur et/ou la dimension d'au moins certains desdits spiraux, par retrait ou ajout d'une quantité incrémentale et prédéterminée de matière,
    - d. répéter l'étape b. et éventuellement l'étape c. si le résultat de l'étape b. indique que la raideur et/ou la dimension n'est pas dans une plage de tolérance prédéfinie.

2. Procédé selon la revendication 1, **caractérisé en ce que** l'étape b. se fait par comparaison par rapport à une référence.

3. Procédé selon l'une des revendications précédentes, **caractérisé en ce que** les dimensions prédéterminées sont supérieures à des dimensions cibles, et **en ce que** l'étape c. se fait par retrait de matière.

4. Procédé selon la revendication 3, **caractérisé en ce que** le retrait se fait par :

- une étape d'oxydation du spiral, afin de transformer en dioxyde de silicium un incrément d'épaisseur de silicium, d'une valeur prédéterminée et indépendante du résultat de l'évaluation de l'étape b,
- retirer au moins une partie du dioxyde de silicium du spiral précédemment oxydé.

5. Procédé selon la revendication 4, **caractérisé en ce que** l'étape de retrait de dioxyde de silicium conduit à laisser une couche résiduelle de dioxyde de silicium d'une épaisseur prédéterminée.

6. Procédé selon l'une des revendications précédentes, **caractérisé en ce que** l'étape b. est réalisée par mesure de la fréquence dudit spiral couplé avec un balancier de référence doté d'une inertie connue.

7. Procédé selon l'une des revendications 1 à 5, **caractérisé en ce que** l'étape b. est réalisée par mesure du couple du spiral.

8. Procédé selon la revendication 7, **caractérisé en ce que** la mesure du couple est réalisée par mise en rotation de la virole, alors que la dernière spire du spiral est attachée.

9. Procédé selon l'une des revendications précédentes, **caractérisé en ce que** l'étape b. est effectuée sur un échantillonnage de spiraux, répartis par région sur la plaquette et **en ce que** l'étape c. est effectuée de manière différentielle par région, en fonction du résultat de l'étape b.

10. Procédé selon l'une des revendications précédentes, dans lequel la quantité incrémentale et prédéterminée de matière ajoutée ou retirée à l'étape c est indépendante de l'évaluation de la raideur et/ou de la dimension effectuée à l'étape b.

11. Procédé selon l'une des revendications précédentes, dans lequel l'étape b. comprend une étape consistant à classifier ou catégoriser la raideur et/ou la dimension dans des classes ou catégories de raideur et/ou de dimension.

12. Procédé selon la revendication précédente, dans lequel au moins deux classes de raideur et/ou de dimension sont définies comme suit :

- raideur et/ou dimension trop faible, auquel cas, l'étape c comprend l'ajout d'une quantité incrémentale et prédéterminée de matière,
- raideur et/ou dimension trop grande, auquel cas, l'étape c comprend le retrait d'une quantité incrémentale et prédéterminée de matière.

FIG. 1

FIG. 2

FIG. 3A

FIG. 3B

FIG. 3C

FIG. 3D

FIG. 3E

FIG. 3F

Fig. 4

**EP 4 030 241 A1**

**RAPPORT DE RECHERCHE EUROPEENNE**

Europäisches Patentamt
European Patent Office
Office européen des brevets

Numéro de la demande

EP 21 15 2156

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2019/180558 A1 (PATEK PHILIPPE SA GENEVE [CH]) 26 septembre 2019 (2019-09-26) | 1-6,9-12 | INV. G04B17/06 G04D7/10 G04D7/12 B81C1/00 |
| Y | * figures 2-4 * * page 4, ligne 15 - page 9, ligne 6 * ----- | 7,8 | |
| Y,D | EP 3 654 111 A1 (NIVAROX SA [CH]) 20 mai 2020 (2020-05-20) * figures 1, 2 * ----- | 7,8 | |
| X | CH 702 708 B1 (SIGATEC S A [CH]) 31 août 2011 (2011-08-31) * figure 1 * * alinéas [0009], [0014], [0017] * ----- | 1-3,6,10 | |
| X | CH 711 962 A2 (CSEM CENTRE SUISSE D'ELECTRONIQUE ET DE MICROTECHNIQUE SA - RECH ET DÉ) 30 juin 2017 (2017-06-30) | 1-4,10, 11 | |
| A | * figures 5, 6 * * alinéa [0027] - alinéa [0049] * ----- | 5,9,12 | DOMAINES TECHNIQUES RECHERCHES (IPC) G04B G04F G04D B81C |

Le présent rapport a été établi pour toutes les revendications

| Lieu de la recherche | Date d'achèvement de la recherche | Examinateur |
|---|---|---|
| Berlin | 10 juin 2021 | Meister, Martin |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 21 15 2156

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-06-2021

| Document brevet cité au rapport de recherche | Date de publication | Membre(s) de la famille de brevet(s) | Date de publication |
|---|---|---|---|
| WO 2019180558 A1 | 26-09-2019 | CN 111919176 A | 10-11-2020 |
| | | EP 3769161 A1 | 27-01-2021 |
| | | TW 201945873 A | 01-12-2019 |
| | | US 2021003971 A1 | 07-01-2021 |
| | | WO 2019180558 A1 | 26-09-2019 |
| EP 3654111 A1 | 20-05-2020 | CN 111190340 A | 22-05-2020 |
| | | EP 3654111 A1 | 20-05-2020 |
| | | JP 2020085901 A | 04-06-2020 |
| | | KR 20200057634 A | 26-05-2020 |
| | | US 2020159171 A1 | 21-05-2020 |
| CH 702708 B1 | 31-08-2011 | AUCUN | |
| CH 711962 A2 | 30-06-2017 | CH 711962 A2 | 30-06-2017 |
| | | CN 106896700 A | 27-06-2017 |
| | | EP 3181940 A1 | 21-06-2017 |
| | | JP 6343653 B2 | 13-06-2018 |
| | | JP 2017111133 A | 22-06-2017 |
| | | US 2017176941 A1 | 22-06-2017 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1422436 A
- EP 2215531 A
- WO 2016128694 A
- WO 2015113973 A
- EP 3181938 A
- EP 3181939 A
- EP 3654111 A

**Littérature non-brevet citée dans la description**

- **M. VERMOT et al.** *Traité de construction horlogère,* 2011, 178-179